# EUROPEAN PATENT APPLICATION

(11) **EP 4 418 316 A1**
(43) Date of publication of application: **21.08.2024**
(21) Application number: 23157121.7
(22) Date of filing: 16.02.2023
(51) Int. Cl.: H01L 23/495

(54) **DIE PADDLE STANDOFFS IN SEMICONDUCTOR PACKAGES**

(71) Applicant: Nexperia B.V., 6534 AB Nijmegen (NL)
(72) Inventor: Dimaano Jr, Antonio B., Cabuyao (PH); Yandoc, Ricardo, Manchester, SK7 5BJ (GB); Malveda, Homer, Cabuyao (PH); Fadullo, Marlon, Cabuyao (PH)
(74) Representative: Pjanovic, Ilija

(57) **Abstract**

A leadframe (202) for a semiconductor package is proposed, comprising one or more mechanical standoffs (204) for placing a die (208) at a distance from the leadframe defined by a height of the standoffs and for enabling an adhesive layer (206) between the leadframe and the die for bonding the die to the leadframe. The leadframe includes a substantially planar surface and the standoffs protrude from this surface. Surrounding perimeters, if present, of the leadframe are lower than the standoffs. The leadframe and the standoffs are a one-piece of conducting material and form a die paddle.

## Description

### Technical field

The present disclosure relates to a leadframe for a semiconductor package, a semiconductor package including a leadframe and a method of generating a leadframe, wherein the leadframe forms a die paddle for such semiconductor package.

### Background

Semiconductor dies are cut from a wafer and attached to a leadframe or substrate and then encapsulated with, e.g., a plastic material to protect the die from being physically damaged. The die typically includes a plurality of electrodes or die bond pads on its "active" surface. These electrodes are connected to corresponding connection points (e.g., lead fingers) on the leadframe or substrate in order to connect the die electrodes to package pins, which are external connection points that facilitate connection of the die internal circuitry to external circuitry.

The leadframe is a metal frame that typically includes a die paddle, also known as die pad, and a plurality of peripherally-located leads that surround the die pad. The die pad mounts the semiconductor chip (or "die"). The die may be bonded to the leadframe and the die pad using an adhesive material, such as solder. Ideally, this adhesive material forms a layer having a uniform bond line thickness (BLT). Power, ground, and/or signal leads of the leadframe are typically electrically connected to power, ground, and/or signal sites on the chip and serve as external connecting means for the chip.

While older technology utilized wire bonding, newer technology includes flip chip bonding processes where the active side of the IC chip is bonded to an electrical circuit of the printed circuit board (PCB) through solder bumps deposited either on the IC chip or the PCB. Alternatively, clips may be used to form external connections to external terminals. Such semiconductor die packages are sometimes referred to as "wireless" packages. A typical wireless package includes a clip that is attached to a semiconductor die.

Examples of semiconductor chips include field-effect transistors (FETs) and metal-oxide-semiconductor field-effect transistors (MOSFETs), wherein a transistor adjacent to an input terminal is known as the control FET or high-side (HS) transistor, and a transistor adjacent to the ground is known as the synchronous FET or low-side (LS) transistor. Generally, the HS is relatively more positive than the LS, though it is not necessary that either the high or the low side has any particular relationship to ground.

The packaged die may be provided in various package types, such as a thin shrink small outline package (TSSOP) or Dual Flat No-leads (DFN) to accommodate different user requirements.

Die pad tilt is a known issue for a semiconductor package. Die pad tilt may cause solder fatigue during stringent condition, similar to reliability test conditions such as Temp Cycling (TC) testing or Intermittent Operating Life (IOL) testing. Furthermore, it may result in decreased solder volume uniformity, thus a non-uniform BLT, where one side has more volume compared to the other side. Die tilting may occur, e.g., during reflow due to planarity of die pad, or due to clip weight which can cause the die to tilt during reflow. Furthermore, a larger die size may cause unsettling of the die or movement during reflow.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure aims to overcome the drawbacks identified in the background section. In particular, the present disclosure aims to control die pad tilt between a die paddle and a die within a semiconductor package, thereby enabling a substantially uniform BLT.

According to an aspect of the disclosure a leadframe for a semiconductor package is proposed. The leadframe may comprise one or more mechanical standoffs for placing a die at a distance from the leadframe defined by a height of the standoffs. The mechanical standoffs further enable a distance between the leadframe and the die to enable an adhesive layer, e.g., solder, to be applied between the leadframe and the die for bonding the die to the leadframe. The leadframe may include a substantially planar surface. The standoffs may protrude from the substantially planar surface. Surrounding perimeters of the leadframe may be lower than the standoffs. It is possible that there is no surrounding perimeter on the leadframe. The leadframe and the standoffs may be a one-piece of conducting material, i.e., formed from a single piece of conducting material. The leadframe including the standoffs may forms a die paddle.

According to another aspect of the disclosure a semiconductor package is proposed. The semiconductor package may include a leadframe according to any one of the above described embodiments.

In an embodiment the semiconductor package may include a MOSFET die. The MOSFET die may be bonded to the leadframe via an adhesive layer, e.g., solder, between the leadframe and the MOSFET die, wherein the leadframe is according to any one of the above described embodiments.

According to another aspect of the disclosure a method of generating one or more mechanical standoffs on a leadframe for a semiconductor package is proposed. The standoffs may be arranged for placing a die at a distance from the leadframe defined by a height of the standoffs. The mechanical standoffs further enable a distance between the leadframe and the die to enable an adhesive layer, e.g., solder, to be applied between the leadframe and the die for bonding the die to the leadframe. The leadframe including the standoffs may form a die paddle. The method may include creating a substantially planar surface on the leadframe with standoffs protruding from the substantially planar surface. The leadframe and the standoffs may be a one-piece of conducting material, i.e., formed from a single piece of conducting material.

The adhesive layer typically includes solder, but any other suitable adhesive material may be used.

In an embodiment the conducting material may be copper.

In an embodiment the standoffs may be created from the one-piece of conducting material using a stamping process. Thus, the standoffs may be formed by pressing the die paddle. Alternatively, the standoffs may be created from the one-piece of conducting material using an etching process. Alternatively, the standoffs may be created from the one-piece of conducting material using a laser ablation process. When created, the surrounding perimeters of the leadframe are preferably lower than the standoffs.

In an embodiment the standoffs may be created by a process having a minimum resolution of about 5um. For example, a standoff may be created by such process, resulting in a standoff width of about 5um.

In an embodiment the standoffs may be geometrically shaped as at least one of: a cylindrical shape; a rectangular shape; an at least partially spherical shape; an at least partially oval shape.

In an embodiment the height of the standoffs may be substantially the same, enabling the adhesive layer to have a substantially uniform BLT. A substantially uniformity BLT during reflow may be achieved, as the BLT will typically be determined by the defined standoff on the die paddle.

In an embodiment the leadframe including the standoffs may form a HS die paddle.

In an embodiment the leadframe may include three mechanical standoffs.

In an embodiment the standoffs may be part of a top die paddle. Alternatively, the standoffs may be part of a bottom die paddle. This enables, e.g., dual cool packages and standard packages.

Advantageously, the leadframe according to the present disclosure can ensure coplanarity of solder or similar adhesive material in the adhesive layer. During production, the adhesive layer will typically undergo a curing process. After curing, the adhesive layer may be of a higher quality, e.g., having little to no cracks in the adhesive layer due to the coplanarity of the adhesive material in the adhesive layer. Furthermore, the standoffs can ensure that the die is placed at an optimal distance from the planar surface of the leadframe, e.g., for an optimal thickness of the adhesive layer or for an even distribution of the adhesive layer to ensure that the die doesn't tilt.

### Brief description of the Drawings

Embodiments of the present disclosure will now be described, by way of example only, with reference to the accompanying schematic drawings in which corresponding reference symbol indicate corresponding parts, in which:
Fig. 1 shows a 3-dimensional representation of a die paddle including a leadframe with mechanical standoffs according to an example embodiment of the present disclosure;
Fig. 2 shows a cross-section view of a leadframe with a die placed on the leadframe according to an example embodiment of the present disclosure;
Fig. 3 shows a cross-section view of semiconductor package including a leadframe according to an example embodiment of the present disclosure;
Fig. 4a shows a cross-section view of an ideal solder BLT and distribution;
Figs. 4b and 4c show a cross-section view of prior art solder BLT and distribution;
FIG. 4d shows a cross-section view of solder BLT and distribution according to an example embodiment of the present disclosure; and
Figs. 5a-5c show a process of a stamping process for producing a leadframe according to an example embodiment of the present disclosure.

The figures are intended for illustrative purposes only, and do not serve as restriction of the scop of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure can be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

The present disclosure provides an improved die paddle for enabling volume uniformity of the adhesive layer between a leadframe and a die. Hereto an improved leadframe is proposed. Thus, it can be avoided that, e.g., one side of the adhesive layer has more volume compared to the other side, which traditionally can be attributed to unoptimized dispensing or printing processes. Furthermore, the improved die paddle makes a die less susceptible to clip weight, which traditionally can cause die to tilt during reflow. Moreover, larger die sizes, which traditionally can cause unsettling of the die or movement of the die during reflow, can be better stabilized. In some embodiments, the present disclosure enables better HS die pad planarity.

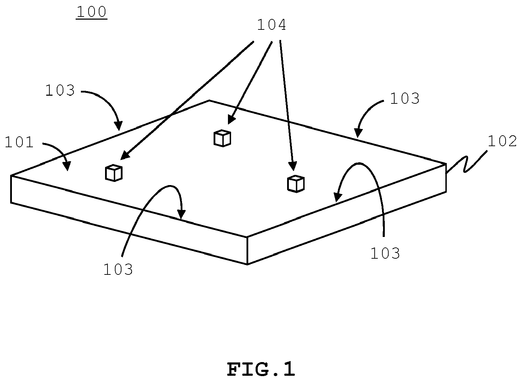

Fig. 1 shows a best mode embodiment of a die paddle 100. The die paddle 100 is, e.g., a HS die paddle. The die paddle 100 includes a leadframe 102, which may also be referred to as a bottom frame of the die paddle 100. To avoid die pad tilt and enable a uniform BLT, the leadframe 102 may include one or more mechanical standoffs 104. The leadframe 102 may have a substantially planar surface, with standoffs 104 protruding from the planar surface. The standoffs 104 may form a basis for holding a die at a distance defined by the height of the standoffs 104 from the planar surface of the leadframe 102. The leadframe 102 may include one or more surrounding perimeters 103, which are lower than the standoffs. Preferably, the height of the surrounding perimeter is zero, in which case effectively there is no surrounding perimeter 103, such as shown in Fig. 1. The height of the surrounding perimeter 103 may thus be defined as 0 ≤ Height_{surrounding perimeter 103} < Height_{standoffs 104}.

In Fig. 1 three standoffs 104 are shown. Three standoffs 104 is typically enough to establish planarity, where a die is placeable on the die paddle 100 substantially parallel to the planar surface of the leadframe 102 and enabling a substantially uniform BLT. The present disclosure is not limited to a leadframe 102 having three standoffs 104. Any number of standoffs 104 may be used, with three standoffs 104 being preferred. The standoffs 104 may also be referred to as 'pillars'.

The leadframe 102 and the mechanical standoffs 104 may be of a conducting material, preferably copper (Cu), or a combination of metals or alloy on top of copper, e.g., Ag plated or PPF plated. The standoffs 104 may be integral parts of the leadframe 102, i.e., the standoffs 104 and the leadframe 102 may be a one-piece of material, e.g., created from a single piece of material such as copper.

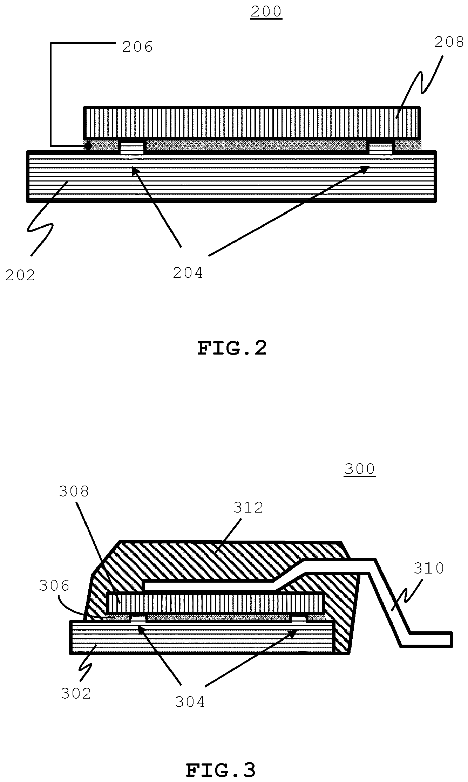

Fig. 2 shows an example embodiment of an assembly 200 including a die paddle and a die 208. The die paddle may include a leadframe 202 having standoffs 204, similar to the die paddle 100 of Fig. 1. The die 208, e.g., a MOSFET die, may be placed on the standoffs 204 of the leadframe 202. In between the leadframe 202 and the die 208, an adhesive layer 206 may be formed for bonding the die to the leadframe 202. The adhesive layer may be solder or any equivalent adhesive such as Ag or Cu materials, enabling a conductive adhesive bonding between the die and the leadframe.

Advantageously, the standoffs 204 enable the adhesive material of the adhesive layer to be substantially uniformly distributed, i.e., resulting in a substantially uniform BLT.

Fig. 3 shows an example embodiment of a semiconductor package 300. The semiconductor package 300 may include an assembly similar to assembly 200 of Fig. 2, and may include a leadframe 302 with one or more standoffs 304, a die 308 and an adhesive layer 306 between the leadframe 302 and the die 308. The semiconductor package 300 may further include a clip 310, which has been bonded to the die 308, typically on another side of the die 308 as where the leadframe 302 has been bonded. The semiconductor package 300 may further include an encapsulation 312 to shield the die 308 from external influences. The leadframe 302 and the clip 310 may be partially extending through the encapsulation 312 to be accessible from outside of the semiconductor package 300, typically for electrical connection to other electronic elements or circuits.

Advantageously, the standoffs 304 enable a substantially uniform BLT. Moreover, the standoffs 304 stabilize the die, keeping the clip 310 from tilting the die 306, e.g. during reflow.

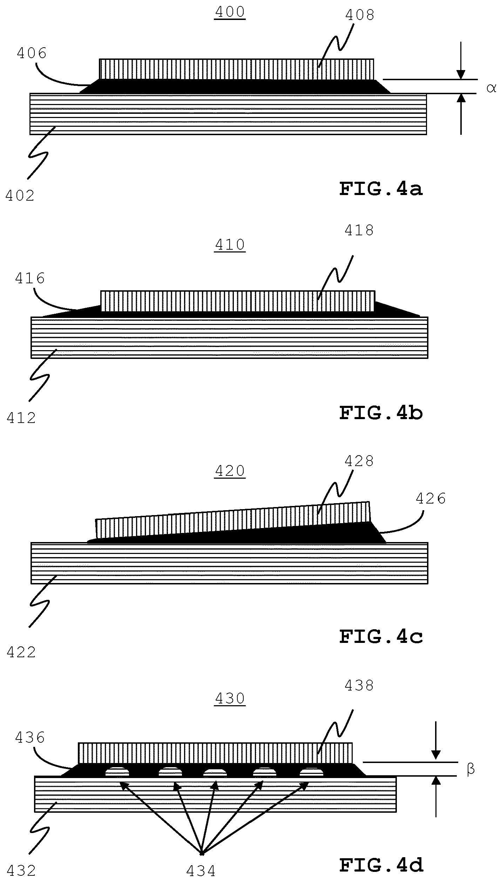

Fig. 4a shows an example 400 of a BLT and distribution of an adhesive layer 406 that may be considered ideal. The adhesive layer 406, e.g., a high lead (Pb) solder alloy, may be used for bonding a leadframe 402 and a die 408. Ideally, the adhesive layer 406 is evenly distributed between the leadframe 402 and the die 408, with thick solder on all corners, depicted in Fig. 4a by the reference "α".

In practice, the BLT and distribution of the adhesive layer may be less than ideal. In the example 410 of Fig. 4b it is shown how the adhesive layer 416, e.g., including solder, between a leadframe 412 and a die 418 may be too thin on corners of the die, resulting in a lower stack height with a risk of mould bleeding. The example 420 of Fig. 4c, showing a leadframe 422, an adhesive layer 426 and a die 428, illustrates how thin adhesive material, such as thin solder, on one corner of the die 428 (i.e., on the left side of the adhesive layer 426 in Fig. 4c) may result in die tilting.

Fig. 4d shows an embodiment of the present application, wherein a leadframe 432 includes mechanical standoffs 434. The thus achieved die paddle may be similar to the embodiment of Fig. 1, although the number of standoffs and the location of the standoffs on the leadframe may differ. The standoffs 434, which may be from the same conducting material as the leadframe 432 and may form a one-piece with the leadframe 432, enable the adhesive material in the adhesive layer 436 to evenly flow between the leadframe 432 and the die 438 during production, resulting in a substantially even BLT and evenly distributed adhesive layer 436, depicted in Fig. 4d by the reference "β". Moreover, the standoffs 434 prevent the die 438 from tilting. Thus, above described problems, such as shown in Figs. 4b and 4c, can be prevented.

When adhesive material becomes trapped on the leadframe, mould bleeding may occur, which is to be prevented. Therefore, preferably the leadframe 432 does not have raised edges on one or more of its outer edges to prevent the adhesive material of the adhesive layer 436 being trapped on the leadframe 432 during reflow, i.e., when the die 438 is being bonded to the leadframe 432. A profile for standoff may be applied, such as tapered or chamfered, to eliminate such issues, but the present disclosure is not limited to such solutions.

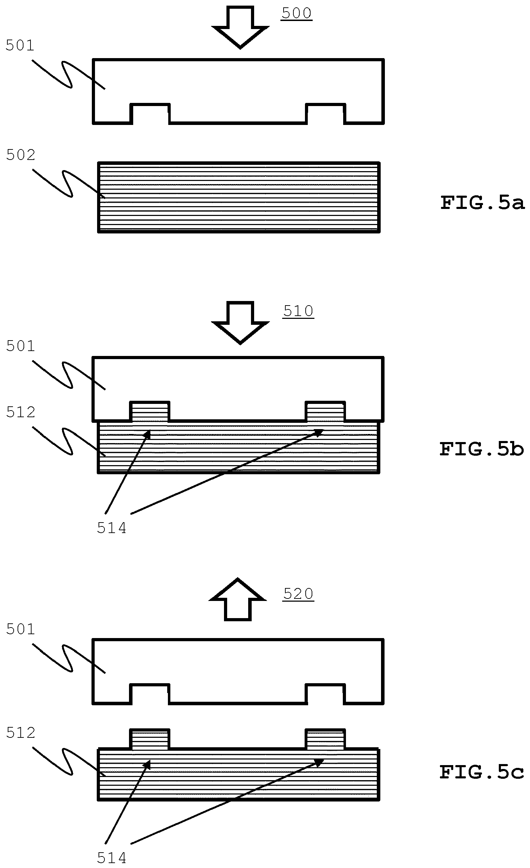

A leadframe including standoffs, such as shown in Figs. 1, 2, 3, 4d and 5c, may be created mechanically from a piece of conducting material, such that the standoffs and the leadframe form a one-piece of conducting material. An example stamping process of creating standoffs on a leadframe is shown in Figs. 5a-5c, where the arrow indicates a direction of movement of a puncher 501. In this example, standoffs 514 may be created on a leadframe 512 from a single piece of material 502 by a stamping process using puncher 501. The material 502 may be any suitable material for functioning as a leadframe in a semiconductor package. Typically, the material 502 includes or consists of a conducting material, for example copper.

The puncher 501 may be shaped to include a substantially flat surface and one or more holes to form the substantially plat surface of the leadframe 512 including one or more protruding standoffs 514 when punching the material 502, as shown in step 500 of Fig. 5a. When the puncher 501 presses on the material 502, the protrusions 514 may be formed, as shown in step 510 of Fig. 5b. When the puncher 501 is removed, the leadframe 512 including standoffs 514 may be formed, as shown in step 520 of Fig. 5c.

In a non-limiting example, the thickness of raw material 502 may be 275 um, the compressed material forming the leadframe 512 may be 250 um, and the protruding standoffs 514 may be 25um in length (i.e., measured from the substantially planar surface of the leadframe extending to the top of a standoff). Preferably, the standoffs are created such to have substantially same lengths.

Other processes may be used to create a die paddle, such as leadframe 512 including one or more standoffs 514 as shown in Fig. 5c. Non-limiting examples of other processes are an etching process to remove part of the material 502 and keep the standoffs 514 and a laser ablation process to create the substantially planar surface and the protruding standoffs.

The thus created protruding standoffs may have dimensions in an order of magnitude of 5um or larger, using state of the art processes having patterns with a minimum resolution of 5um. Smaller dimensions may be possible with even higher resolution processes.

The thus created standoffs may be of any suitable shape, such as a cylindrical shape, a rectangular shape, an at least partially spherical shape or an at least partially oval shape. In some embodiments differently shaped standoffs may be created on a single leadframe.

The leadframe including standoffs of the present disclosure may be used in various semiconductor packages, including but not limited to MOSFETs, TrenchMOS, MOS die configurations, clip bond power packages, easy mode (E-Mode) devices, leadframe/clip matrix configuration,

Protrusions may be applied on either top or bottom die paddles, such as in dual cool packages or standard packages. In an embodiment, the leadframe including the standoffs may form a HS die paddle.

## Claims

1. A leadframe (102, 202, 302, 432, 512) for a semiconductor package (300), comprising one or more mechanical standoffs (104, 204, 304, 434, 514) for placing a die (208, 308, 438) at a distance from the leadframe defined by a height of the standoffs and for enabling an adhesive layer (206, 306, 436) between the leadframe and the die for bonding the die to the leadframe,
wherein the leadframe comprises a substantially planar surface (101),
wherein the standoffs protrude from the substantially planar surface,
wherein the leadframe comprises a surrounding perimeter (103) having a height of zero or larger and lower than the standoffs,
wherein the leadframe and the standoffs are a one-piece of conducting material,
and wherein the leadframe including the standoffs forms a die paddle.

2. The leadframe according to claim 2, wherein the conducting material is copper.

3. The leadframe according to any one of the preceding claims,
wherein the standoffs are created from the one-piece of conducting material using one of: a stamping process (500, 510, 520); an etching process; a laser ablation process, and such that the surrounding perimeter of the leadframe is lower than the standoffs.

4. The leadframe according to claim 4, wherein the standoffs are created by a process having a minimum resolution of 5um.

5. The leadframe according to any one of the preceding claims, wherein the standoffs are geometrically shaped as at least one of: a cylindrical shape; a rectangular shape; an at least partially spherical shape; an at least partially oval shape.

6. The leadframe according to any one of the preceding claims, wherein the height of each of the standoffs is substantially the same, enabling the adhesive layer to have a substantially uniform bond line thickness, BLT.

7. The leadframe according to any one of the preceding claims, wherein the leadframe including the standoffs forms a high-side, HS, die paddle.

8. The leadframe according to any one of the preceding claims, comprising three standoffs.

9. The leadframe according to any one of the preceding claims, wherein the standoffs are part of one of: a top die paddle; a bottom die paddle.

10. A semiconductor package (300) comprising a leadframe (102, 202, 302, 432, 512) according to any one of the claims 1-9.

11. The semiconductor package according to claim 10, further comprising a metal-oxide-semiconductor field-effect transistor, MOSFET, die, wherein the MOSFET die is bonded to the leadframe via an adhesive layer between the leadframe and the MOSFET die.

12. A method of generating one or more mechanical standoffs (104, 204, 304, 434, 514) on a leadframe (102, 202, 302, 432, 512) for a semiconductor package (300), wherein the standoffs are arranged for placing a die (208, 308, 438) at a distance from the leadframe defined by a height of the standoffs and for enabling an adhesive layer (206, 306, 436) between the leadframe and the die for bonding the die to the leadframe, and wherein the leadframe including the standoffs forms a die paddle, the method comprising:
creating (500, 510, 520) a substantially planar surface on the leadframe with standoffs protruding from the substantially planar surface, wherein the leadframe and the standoffs are a one-piece of conducting material, and wherein a surrounding perimeter of the leadframe has a height of zero or larger and lower than the standoffs.

13. The method according to claim 12, wherein the method comprises one of:
stamping (500, 510, 520) a piece of conducting material (502) using a puncher (501) having an inverted shape of the substantially planar surface and standoffs protruding from the substantially planar surface;
etching a piece of conducting material to remove part of the material and keeping the standoffs;
using a laser ablation process to create the substantially planar surface and the protruding standoffs.

14. The method according to claim 13, wherein the standoffs are created by a process having a minimum resolution of 5um.

15. The method according to any one of the claims 12-14, wherein the standoffs are created having at least one of: a cylindrical shape; a rectangular shape; an at least partially spherical shape; an at least partially oval shape.
